# EUROPÄISCHE PATENTSCHRIFT

(11) **EP 2 984 496 B1**
(45) Veröffentlichungstag und Bekanntmachung des Hinweises auf die Patenterteilung: **05.06.2019**
(21) Anmeldenummer: 14727390.8
(22) Anmeldetag: 04.04.2014
(51) Int. Cl.: G01R 31/319, G01R 31/28, G06F 11/36

(54) **MODULARE TESTUMGEBUNG FÜR EINE MEHRZAHL VON TESTOBJEKTEN**
MODULAR TEST ENVIRONMENT FOR A PLURALITY OF TEST OBJECTS
ENVIRONNEMENT DE TEST MODULAIRE POUR UNE PLURALITÉ D'OBJETS À TESTER

(30) Priorität: 09.04.2013 DE 102013006011
(43) Veröffentlichungstag der Anmeldung: 17.02.2016
(73) Patentinhaber: Airbus Defence and Space GmbH, 85521 Ottobrunn (DE)
(72) Erfinder: WAGER, Philipp, 84036 Landshut (DE); SCHUMACHER, Bernd, 85049 Ingolstadt (DE)
(74) Vertreter: LKGLOBAL Lorenz & Kopf PartG mbB Patentanwälte
(86) Internationale Anmeldenummer: PCT/DE2014/000170
(87) Internationale Veröffentlichungsnummer: WO 2014/166471

(56) Entgegenhaltungen:
- DE-A1-102008 008 933
- US-A- 4 760 330
- RAJSUMAN R: "An Overview of the Open Architecture Test System", ELECTRONIC DESIGN, TEST AND APPLICATIONS, 2004. DELTA 2004. SECOND IEE E INTERNATIONAL WORKSHOP ON PERTH, AUSTRALIA 28-30 JAN. 2004, PISCATAWAY, NJ, USA,IEEE, 28. Januar 2004 (2004-01-28), Seiten 341-341, XP010778701, DOI: 10.1109/DELTA.2004.10026 ISBN: 978-0-7695-2081-0

## Beschreibung

### Gebiet der Erfindung

Die Erfindung betrifft eine Testumgebung zum Testen von Testobjekten, welche beispielsweise ein technisches System, ein Subsystem eines technischen Systems oder eine sonstige technische Komponente und insbesondere sicherheitsrelevante technische Komponente wie z. B. eine Komponente eines Flugzeugs oder eines Flugzeugcomputers sein kann.

### Hintergrund der Erfindung

Technische Komponenten können erfordern, nach ihrer Entwicklung und vor ihrer Verwendung auf ihr Verhalten in verschiedenen Situationen getestet zu werden. Ein solcher Test kann aus mehreren Testfällen bestehen, wobei jeder Testfall einen Satz von Eingabedaten und einen Satz von erwarteten Ausgangsdaten aufweist. Vereinfacht ausgedrückt wird das Testobjekt mit den Eingabedaten beaufschlagt und die Reaktion bzw. das Verhalten des Testobjekts auf diese Eingabedaten hin erfasst. Die so erfassten Daten werden anschließend mit den diesem Testfall zugeordneten erwarteten Ausgangsdaten verglichen. Eine Übereinstimmung zwischen den erfassten Daten und den erwarteten Ausgabedaten deutet auf eine richtige Funktion des Testobjekts in dem entsprechenden Testfall hin. Ein Abweichen der erfassten Daten von den vorgegebenen und erwarteten Ausgangsdaten kann auf eine Fehlfunktion des Testobjekts hinweisen.

Unter Umständen kann es erforderlich sein, eine Testumgebung auf ein bestimmtes Testobjekt anzupassen, sei es betreffend die mechanische Kopplung des Testobjekts mit der Testumgebung oder die signaltechnische Kopplung des Testobjekts mit der Testumgebung zur Beaufschlagung des Testobjekts mit den Eingangsdaten eines Testfalls und zum Auslesen der Ausgangsdaten im Anschluss an einen Testfall.

Ein Testfall wird üblicherweise von einer Testfalldurchführungseinheit gestartet und die Durchführung des Testfalls überwacht, wobei eine einzelne Testfalldurchführungseinheit bereitgestellt wird, um Testfälle an dem Testobjekt durchzuführen. Wird ein neuartiges oder variiertes Testobjekt zum Testen in der Testumgebung bereitgestellt, so kann es erforderlich sein, die Testumgebung an das variierte Testobjekt anzupassen.

Rajsuman, R.: "An Overview of the Open Architecture Test System", Electronic design, test and applications, 2004, DELTE 2004, Second IEEE International Workshop on Perth, Australia, 28-30 Jan 2004, Piscataway, NJ, USA, IEEE, 28. Januar 2004, Seite 341 beschreibt ein Framework für das Testen von Software- und Hardwarekomponenten. D1 beschreibt insbesondere, dass für die Anbindung von Hardwarekomponenten standardisierte Schnittstellen genutzt werden.

### Zusammenfassung der Erfindung

Es kann als eine Aufgabe der Erfindung betrachtet werden, eine Testumgebung für eine Vielzahl verschiedener Testobjekte anzugeben.

Diese Aufgabe wird erfüllt durch die Testumgebung mit den Merkmalen gemäß dem unabhängigen Patentanspruch. Weiterbildungen der Erfindung ergeben sich aus den abhängigen Patentansprüchen und aus der folgenden Beschreibung.

Gemäß einem Aspekt der Erfindung ist eine Testumgebung zum Testen von Testobjekten angegeben. Die Testumgebung weist eine erste Testobjektaufnahmeeinrichtung und eine zweite Testobjektaufnahmeeinrichtung auf, welche ausgeführt sind, jeweils ein Testobjekt aufzunehmen. Die Testumgebung weist weiterhin eine Anschlussschnittstelle zum Anschließen einer der ersten Testobjektaufnahmeeinrichtung und der zweiten Testobjektaufnahmeeinrichtung an die Testumgebung auf. Die erste Testobjektaufnahmeeinrichtung weist eine erste externe Anschlussschnittstelle und die zweite Testobjektaufnahmeeinrichtung eine zweite externe Anschlussschnittstelle auf, welche externen Anschlussschnittstellen beide ausgeführt sind, wahlweise mit der Anschlussschnittstelle der Testumgebung gekoppelt zu werden.

Damit ermöglicht die Testumgebung das Testen verschiedener Testobjekte, ohne dass dabei die Testumgebung an die Schnittstellen der Testobjekte angepasst werden muss, da die Testobjekte über die Testobjektaufnahmeeinrichtungen mit der Testumgebung gekoppelt werden. Die erste externe Anschlussschnittstelle der ersten Testobjektaufnahmeeinrichtung und die zweite externe Anschlussschnittstelle der zweiten Testobjektaufnahmeeinrichtung können insbesondere eine identische mechanische und elektrische Schnittstelle zur Anbindung an die Anschlussschnittstelle der Testumgebung aufweisen.

Die Testumgebung wie oben und im Folgenden beschrieben kann damit beispielsweise ermöglichen, dass die Testumgebung für verschiedenste Testobjekte verwendet werden kann, ohne dass die Testumgebung an die mechanischen und elektrischen Schnittstellen eines neuartigen Testobjektes angepasst werden muss.

Gemäß einer Ausführungsform ist der Zugriff einer Testfalldurchführungseinheit auf ein Testobjekt orts- und zeitunabhängig möglich. Ortsunabhängig bedeutet, dass eine Testfalldurchführungseinheit von einem beliebigen Ort aus und insbesondere über Fernzugriff von einem entfernten Ort aus auf ein Testobjekt zugreifen kann. Zwischen dem Testobjekt und dem entfernten Ort kann insbesondere eine unmittelbare Sichtverbindung, z.B. eines Bedieners der Testfalldurchführungseinheit, nicht bestehen. Zeitunabhängig bedeutet, dass zu einer beliebigen Zeit von einer Testfalldurchführungseinheit auf ein Testobjekt zugegriffen werden kann.

Gemäß einer Ausführungsform sind die Testobjekte räumlich voneinander getrennt.

Dies ermöglicht insbesondere das Zusammenwirken mehrerer räumlich voneinander getrennt angeordneter Testobjekte in einem gemeinsamen Testszenario.

Gemäß einer Ausführungsform der Erfindung stimmt eine mechanische Spezifikation der ersten externen Anschlussschnittstelle mit einer mechanischen Spezifikation der zweiten externen Anschlussschnittstelle überein.

Dies bedeutet, dass die Testumgebung bzw. die Anschlussschnittstelle der Testumgebung ausgeführt ist, über eine festgelegte und gleichbleibende mechanische Spezifikation mit einer Vielzahl von Testobjektaufnahmeeinrichtungen jeweils über deren externe Anschlussschnittstelle verbunden zu werden. Unter einer mechanischen Spezifikation einer Anschlussschnittstelle ist beispielsweise die Anzahl der Verbindungspunkte bzw. Verbindungspole, die Anordnung der Verbindungspunkte und die Art der mechanischen Kopplung zwischen der ersten externen Anschlussschnittstelle bzw. zweiten externen Anschlussschnittstelle und der Anschlussschnittstelle der Testumgebung zu verstehen.

Gemäß einer weiteren Ausführungsform der Erfindung stimmt eine elektrische Spezifikation der ersten externen Anschlussschnittstelle mit einer elektrischen Spezifikation der zweiten externen Anschlussschnittstelle überein.

Die elektrische Spezifikation einer Anschlussschnittstelle betrifft die Art der Signalübertragung über diese Anschlussschnittstelle, d. h. den Spannungspegel der Signale, die Anzahl und den Spannungsabstand zwischen den einzelnen Signalwerten, ggf. eine Modulation der übertragenen Signale und ggf. die Signalkodierung der übertragenen Signale.

Gemäß einer weiteren Ausführungsform der Erfindung stimmt neben der mechanischen und elektrischen Spezifikation der ersten externen Anschlussschnittstelle und der zweiten externen Anschlussschnittstelle auch eine signalübertragungstechnische Spezifikation dieser beiden externen Anschlussschnittstellen überein. Dies kann beispielsweise bedeuten, dass die externen Anschlussschnittstellen der Testobjektaufnahmeeinrichtungen von der Testumgebung über einen einheitlichen gemeinsamen Befehlssatz angesteuert werden oder dass ein Datenübertragungsprotokoll zwischen der Testumgebung und sämtlichen Testobjektaufnahmeeinrichtungen identisch ist.

In anderen Worten ermöglicht die Erfindung das Bereitstellen einer einheitlichen Testumgebung mit vorgegebener Spezifikation der Anschlussschnittstelle zu einer Mehrzahl von Testobjektaufnahmeeinrichtungen, welche Testobjektaufnahmeeinrichtungen ihrerseits jeweils individuell ausgestaltete Testobjekte aufnehmen und beherbergen können.

Gemäß einer weiteren Ausführungsform der Erfindung weist die erste Testobjektaufnahmeeinrichtung eine erste interne Schnittstelle und die zweite Testobjektaufnahmeeinrichtung eine zweite interne Schnittstelle auf, wobei die zweite interne Schnittstelle von der ersten internen Schnittstelle abweicht. Dabei ist die erste interne Schnittstelle ausgeführt, mit einem ersten Testobjekt gekoppelt zu werden und die zweite interne Schnittstelle ist ausgeführt, mit einem zweiten Testobjekt, welches von dem ersten Testobjekt abweicht, gekoppelt zu werden.

Dass die erste interne Schnittstelle von der zweiten internen Schnittstelle abweicht bedeutet, dass diese beiden internen Schnittstellen sich in zumindest einem Aspekt ihrer Spezifikation, d. h. der mechanischen, elektrischen oder signalübertragungstechnischen Spezifikation, voneinander unterscheiden. Entsprechend bedeutet dies auch für das Abweichen des ersten Testobjekts von dem zweiten Testobjekt, dass das erste Testobjekt in zumindest einem Aspekt der dargelegten Spezifikation von dem zweiten Testobjekt abweicht. Die Testobjekte können sich daneben auch dadurch unterscheiden, dass sie unterschiedliche Funktionen ausführen und mittels unterschiedlicher Befehlssätze angesteuert werden.

Gemäß einer weiteren Ausführungsform der Erfindung weicht eine mechanische Spezifikation der ersten internen Schnittstelle von einer mechanischen Spezifikation der zweiten internen Schnittstelle ab.

Gemäß einer weiteren Ausführungsform der Erfindung weist eine elektrische Spezifikation der ersten internen Schnittstelle von einer elektrischen Spezifikation der zweiten internen Schnittstelle ab.

Gemäß einer weiteren Ausführungsform der Erfindung weist eine signalübertragungstechnische Spezifikation der ersten internen Schnittstelle von eine signalübertragungstechnischen Spezifikation der zweiten internen Schnittstelle ab.

Für die mechanische, elektrische und signalübertragungstechnische Spezifikation der ersten und zweiten internen Schnittstelle gilt das weiter oben zu der ersten und zweiten externen Anschlussschnittstelle der Testobjektaufnahmeeinrichtungen Geschriebene analog.

Die interne Schnittstelle einer Testobjektaufnahmeeinrichtung ist damit ausgeführt, mit einem Testobjekt gekoppelt zu werden und die externe Anschlussschnittstelle der Testobjektaufnahmeeinrichtung ist ausgeführt, über eine einheitliche Anschlussschnittstelle der Testumgebung mit dieser gekoppelt zu werden. In anderen Worten ermöglicht die Testumgebung mit einer solchen Testobjektaufnahmeeinrichtung das Koppeln und Testen verschiedenartiger und variierender Testobjekte an eine Testumgebung über eine gleichbleibende Anschlussschnittstelle der Testumgebung, d. h. dass die Testobjektaufnahmeeinrichtung die mechanische, elektrische und signalübertragungstechnische Spezifikation eines Testobjektes kapselt und der Testumgebung ermöglicht, das Testobjekt über gleichbleibende und vorherbestimmte externe Anschlussschnittstellen der Testobjektaufnahmeeinrichtungen anzusprechen.

Gemäß einer weiteren Ausführungsform der Erfindung weist die erste Testobjektaufnahmeeinrichtung eine Signalschnittstelle auf, welche ausgeführt ist, die erste interne Schnittstelle mit der ersten externen Anschlussschnittstelle mechanisch und elektrisch zu koppeln.

Die Signalschnittstelle empfängt damit auf der einen Seite die Signale von der Testumgebung, wandelt diese mechanisch und elektrisch um und gibt sie auf der anderen Seite an das Testobjekt aus. Dies gilt natürlich sinngemäß auch für die Übertragung von Signalen in die andere Richtung, d. h. von dem Testobjekt zu der Testumgebung, und gilt weiterhin neben der mechanischen und elektrischen Kopplung auch für die signalübertragungstechnische Kopplung der Testumgebung mit dem Testobjekt.

Gemäß einer weiteren Ausführungsform der Erfindung weist die Testumgebung einen ersten Signalabgriff auf. Die erste Testobjektaufnahmeeinrichtung weist eine erste Testsignalschnittstelle auf, welche die erste interne Schnittstelle mit dem ersten Signalabgriff mechanisch und elektrisch koppelt.

Der Signalabgriff ermöglicht das Auslesen von Test- und Diagnosesignalen, beispielsweise Signalen über den Betriebszustand des Testobjekts. Bei diesen Test- und Diagnosesignalen kann es sich um Informationen über den Betriebszustand des Testobjekts handeln, die neben den Ausgabedaten des Testobjekts, die für einen Testfall herangezogen werden, überwacht werden können.

Gemäß einer weiteren Ausführungsform der Erfindung weist die zweite Testobjektaufnahmeeinrichtung eine zweite Testsignalschnittstelle auf, welche die zweite interne Schnittstelle mit dem zweiten Signalabgriff mechanisch und elektrisch koppelt, wobei die erste Testsignalschnittstelle und die zweite Testsignalschnittstelle eine übereinstimmende elektrische Spezifikation aufweisen, über welche sie mit der Testumgebung gekoppelt sind.

Damit verfügt die Testumgebung wie oben und im Folgenden beschrieben neben einer vereinheitlichten Möglichkeit der Durchführung eines Testfalls und der Auswertung der Testfalldaten eines Testobjekts über die Möglichkeit eines vereinheitlichten Abgriffs von Test- und Diagnosesignalen über den Betriebszustand verschiedener Testobjekte.

Gemäß einer weiteren Ausführungsform weisen die erste Testsignalschnittstelle und die zweite Testsignalschnittstelle eine übereinstimmende mechanische Spezifikation auf, über welche sie mit der Testumgebung gekoppelt sind.

Die Testumgebung wie oben und im Folgenden beschrieben ermöglicht damit, dass verschiedene und variierende Testobjekte, die insbesondere über wechselnde Eingabe- und Ausgabeschnittstellen verfügen, in einer Testobjektaufnahmeeinrichtung gekapselt bzw. eingeschlossen werden, um so die Schnittstellen des Testobjekts von der Testumgebung zunächst zu trennen. Die Testobjektaufnahmeeinrichtung weist eine interne Schnittstelle auf, die an das Testobjekt angepasst ist und eine externe Schnittstelle, welche an die Testumgebung angepasst ist. Bei einem Wechsel der Schnittstellen eines Testobjekts kann es damit insbesondere ausreichen, eine Testobjektaufnahmeeinrichtung bereitzustellen, die an die Eingangs- und Ausgangsschnittstellen des Testobjekts angepasst ist, ohne dass dabei die Testumgebung als Ganzes an das Testobjekt angepasst werden muss.

Bei den Testobjekten kann es sich um jegliche technische Komponenten handeln, beispielsweise technische Komponenten mit beweglichen Bestandteilen oder aber um Steuer- und Regeleinrichtungen, die für die Überwachung eines technischen Prozesses ausgestaltet sind. Insbesondere kann es sich bei den Testobjekten um Komponenten sicherheitsrelevanter Systeme handeln, beispielsweise um Komponenten die in dem bemannten oder unbemannten Flugverkehr zum Einsatz kommen.

### Kurze Beschreibung der Figuren

Fig. 1 zeigt eine schematische Darstellung einer Testumgebung gemäß einem Ausführungsbeispiel der Erfindung.
Fig. 2 zeigt eine schematische Darstellung einer Testumgebung gemäß einem weiteren Ausführungsbeispiel der Erfindung.
Fig. 3 zeigt eine schematische Darstellung einer Testobjektaufnahmeeinrichtung einer Testumgebung gemäß einem weiteren Ausführungsbeispiel der Erfindung.
Fig. 4 zeigt eine schematische Darstellung einer Testumgebung gemäß einem weiteren Ausführungsbeispiel der Erfindung.

### Detaillierte Beschreibung von Ausführungsbeispielen

Die Darstellungen in den Figuren sind schematisch und nicht maßstabsgetreu. Werden in der folgenden Figurenbeschreibung gleiche Bezugsziffern verwendet, so betreffen diese gleiche oder ähnliche Elemente.

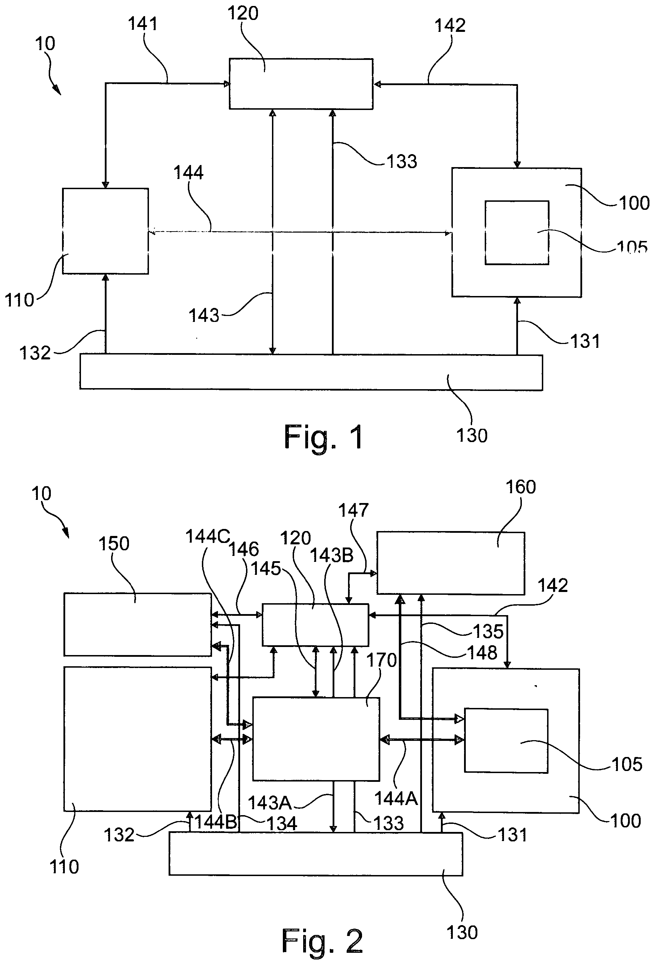

Fig. 1 zeigt eine Testumgebung 10 mit einer Testfalldurchführungseinheit 110 und einem Testobjekt 105, welches in einer Testobjektaufnahmeeinrichtung 100 angeordnet ist. Eine Steuereinrichtung 120 ist vorgesehen, einerseits die Testfalldurchführungseinheit 110 und andererseits die Testobjektaufnahmeeinrichtung 100 und das Testobjekt 105 zu steuern. Ebenso steuert die Steuereinrichtung 120 eine Energieversorgungseinheit 130, welche sowohl die Testfalldurchführungseinheit 110, die Testobjektaufnahmeeinrichtung 100 und das Testobjekt 105 sowie die Steuereinrichtung 120 mit Energie zur Durchführung eines Tests versorgt.

Die unidirektionalen Pfeile 131, 132, 133 stellen schematisch die Energieversorgung der Testobjektaufnahmeeinrichtung 100, der Testfalldurchführungseinheit 110 bzw. der Steuereinrichtung 120 dar. Die Richtung der Pfeile kennzeichnet dabei die Richtung der Bereitstellung von Energie. Die bidirektionalen Pfeile symbolisieren Datenverbindungen zwischen den entsprechenden Komponenten. Die Steuereinrichtung 120 hat eine Datenverbindung 141 zu der Testfalldurchführungseinheit 110, eine Datenverbindung 142 zu der Testobjektaufnahmeeinrichtung 100 bzw. zu dem darin angeordneten Testobjekt 105 und eine Datenverbindung 143 zu der Energieversorgungseinheit 130. Über diese Datenverbindungen erfolgt die Steuerung der gesamten Testumgebung bzw. des Testszenarios.

Daneben existiert noch eine Datenverbindung 144 zwischen der Testfalldurchführungseinheit 110 und der Testobjektaufnahmeeinrichtung 100, wobei über diese Datenverbindung 144 der eigentliche Testfall durch die Testfalldurchführungseinheit 110 initiiert und durchgeführt wird sowie die Ausgabedaten des Testobjekts 105 empfangen werden.

Die Testfalldurchführungseinheit 110 ist ausgeführt, Daten über eine vorgegebene mechanische und elektrische Verbindung 144 mit der Testobjektaufnahmeeinrichtung 100 auszutauschen. Diese Daten werden von der Testobjektaufnahmeeinrichtung 100 angepasst an die Schnittstelle des Testobjekts 105, so dass bei einem neuartigen Testobjekt lediglich die Testobjektaufnahmeeinrichtung 100 an die mechanische und elektrische Schnittstelle des Testobjekts 105 angepasst werden muss, wobei die Verbindung sowohl hinsichtlich der mechanischen als auch der elektrischen Schnittstelle zu der Testfalldurchführungseinheit 110 beibehalten werden kann. In anderen Worten erfolgt hierbei eine sogenannte Kapselung der mechanischen, elektrischen und signaltechnischen Schnittstellen des Testobjekts 105 durch die Testobjektaufnahmeeinrichtung 100, so dass bei einem neuen Testobjekt lediglich die Testobjektaufnahmeeinrichtung 100 an das Testobjekt angepasst wird, ohne dabei die mechanischen, elektrischen und signalübertragungstechnischen Schnittstellen der Testobjektaufnahmeeinrichtung zu der Testfalldurchführungseinheit anzupassen. Das Entwerfen und Qualifizieren einer Testumgebung im Ganzen kann damit weitestgehend verhindert werden, wenn ein neuartiges Testobjekt zu testen ist. Unter dem sogenannten Qualifizieren der Testumgebung versteht man dabei das Überprüfen der Testumgebung an sich auf richtige Funktion.

Fig. 2 zeigt eine Testumgebung 10, die neben den bereits in Fig. 1 gezeigten Komponenten zusätzlich eine Simulationshardwareeinheit 150 und ein Ein-/Ausgabeelement 160 sowie ein Verbindungswerk 170 aufweist.

Das Verbindungswerk 170 ist ausgeführt, die Testfalldurchführungseinheit 110, die Simulationshardwareeinheit 150 und das in der Testobjektaufnahmeeinrichtung 100 befindliche Testobjekt 105 miteinander zu koppeln. Die Kopplung zwischen diesen Komponenten wird über die Steuereinrichtung 120 und die Datenverbindung 145 zwischen der Steuereinrichtung 120 und dem Verbindungswerk 170 gesteuert.

Die Ein-/Ausgabeelemente 160 dienen der lokalen Steuerung des Testobjekts 105 über die Datenverbindung 148. Hierüber kann das Testobjekt beispielsweise eingeschaltet oder in einem Notfall ausgeschaltet bzw. deaktiviert werden. Ebenso könnte über die Elemente 160 ein Betriebsmodus des Testobjekts vorgegeben werden.

Im Gegensatz zu dieser Steuerung des Testobjekts über die in räumlicher Nähe oder sogar Sichtweite zu dem Testobjekt 105 angebrachten Ein-/Ausgabeelemente 160 kann das Initiieren und Durchführen eines Testfalls durch die Testfalldurchführungseinheit 110 über die Datenverbindung 144A, 144B auch über einen Fernzugriff erfolgen. Dies bedeutet, dass die Testfalldurchführungseinheit 110 räumlich getrennt von dem Testobjekt angeordnet ist und die Verbindung beispielsweise über ein öffentliches oder privates Datennetz zwischen dem Testobjekt und der Testfalldurchführungseinheit hergestellt wird.

Ebenso wie die Testfalldurchführungseinheit 110 räumlich getrennt von dem Testobjekt 105 angeordnet sein kann, kann auch die Simulationshardwareeinheit 150 räumlich getrennt von dem Testobjekt 105 angeordnet sein. Dies ermöglicht beispielsweise die gemeinsame Nutzung einer nur einmal vorhandenen Simulationshardwareeinheit 150 durch mehrere verschiedene Testobjekte 105, von denen alle an unterschiedlichen Orten entfernt und unabhängig von der Simulationshardwareeinheit 150 platziert sein können.

Auch hier wird deutlich, dass die Testumgebung 10 wie oben und im Folgenden beschrieben eine Mehrfachverwendung von Komponenten, beispielsweise der Simulationshardwareeinheit 150 ermöglicht, wie auch ein Mehrfachzugriff mehrerer Benutzer, die räumlich getrennt voneinander und von dem Testobjekt sind, auf ein Testobjekt nacheinander ermöglicht wird.

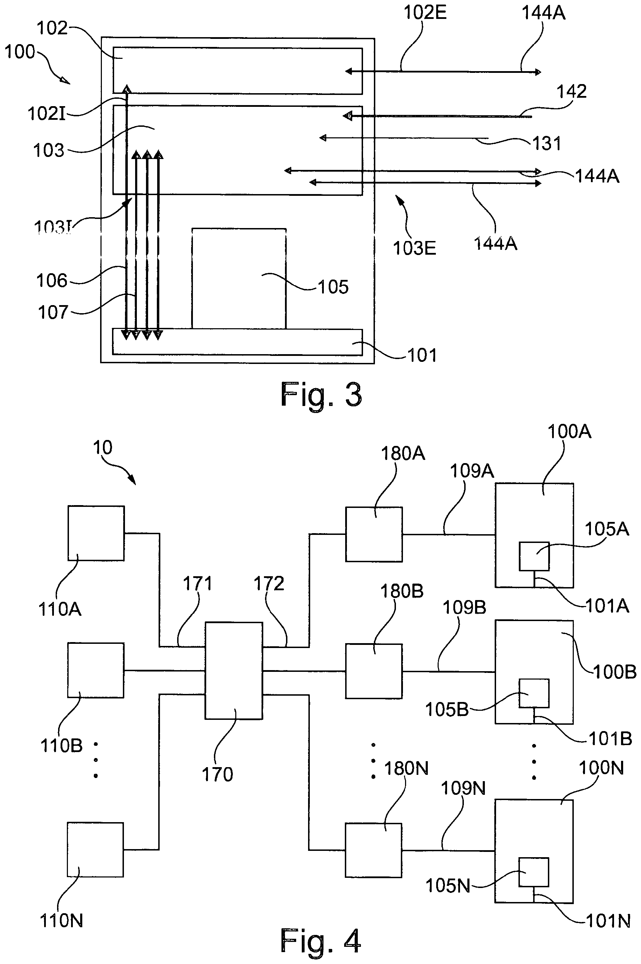

Fig. 3 zeigt eine Testobjektaufnahmeeinrichtung 100 mit einem Testobjekt 105. Das Testobjekt 105 ist mit einem Aufnahmeelement 101 mechanisch und elektrisch gekoppelt. Das Aufnahmeelement 101 bildet damit die Schnittstelle der Testobjektaufnahmeeinrichtung zu dem Testobjekt 105 und ist jeweils an die mechanischen, elektrischen und signalübertragungstechnischen Auflagen zur Verbindung mit dem Testobjekt 105 angepasst.

Die Testobjektaufnahmeeinrichtung 100 weist daneben noch eine Testsignalschnittstelleneinheit 102 und eine Signalschnittstelleneinheit 103 auf. Die Signalschnittstelleneinheit 103 ist ausgeführt, über eine interne Schnittstelle 103I Signale von dem Testobjekt 105 über das Aufnahmeelement 101 entgegen zu nehmen, diese Signale aufzuarbeiten bzw. umzuwandeln und sie über eine externe Schnittstelle 103E über die Datenverbindung 144A an das Verbindungswerk 170 auszugeben. Die Signale des Testobjekts werden von dem Aufnahmeelement 101 über eine Datenverbindung 107 an die Signalschnittstelleneinheit 103 übertragen.

Optional kann die Testobjektaufnahmeeinrichtung 100 eine Testsignalschnittstelleneinheit 102 aufweisen, welche über eine interne Schnittstelle 102I über die Datenverbindung 106 Signale von dem Aufnahmeelement 101 aufnimmt, diese Signale auswertet und ggf. umwandelt und über die externe Schnittstelle 102E und die Datenverbindung 144A ausgibt.

Die Testsignalschnittstelleneinheit 102 ist optional und ermöglicht den Anschluss einer Diagnoseeinheit an die Testobjektaufnahmeeinrichtung, wobei die Diagnoseeinheit Testsignale des Testobjekts auswertet und analysiert.

Die Signalschnittstelleneinheit 103 ist des Weiteren über die Leitung 131 mit der Energieversorgungseinheit 130 verbunden und über die Datenverbindung 142 mit der Steuereinrichtung 120.

In einem Ausführungsbeispiel kann die Testobjektaufnahmeeinrichtung 100 eine abgeschlossene Einheit zum Betrieb des darin eingebetteten Testobjektes 105 sein. Das Aufnahmeelement bzw. die Schnittstelle zum Anschluss des Testobjektes dient der mechanischen, elektrischen und signalübertragungstechnischen Adaption bzw. Kopplung des Testobjekts. Daneben kann das Aufnahmeelement 101 weitere Funktionen beinhalten, wie beispielsweise eine Kühlfunktion, um bei dem Betrieb des Testobjekts entstehende Wärme abzutransportieren. Das Testobjekt wird an dem Aufnahmeelement montiert bzw. befestigt und die Schnittstellen des Testobjekts werden von dem Aufnahmeelement über die Datenverbindungen 106, 107 an die Testsignalschnittstelleneinheit 102 bzw. an die Signalschnittstelleneinheit 103 übertragen. Das Testobjekt 105 kann neben Betriebsschnittstellenanschlüssen auch Diagnose- bzw. Programmierschnittstellenanschlüsse aufweisen. Die Betriebsschnittstellen werden dabei diskret mit der Signalschnittstelleneinheit und die Diagnose- bzw. Programmierschnittstellen werden diskret mit der Testsignalschnittstelleneinheit 102 verbunden. Die Testsignalschnittstelleneinheit ist optional und dient beispielsweise der Fehlersuche oder kann für das Einspielen von Steuerprogrammen in das Testobjekt verwendet werden. Die Signalschnittstelleneinheit 103 führt sämtliche Betriebsschnittstellenanschlüsse des Testobjekts über die externe Schnittstelle 103E aus der Testobjektaufnahmeeinrichtung 100 nach außen. Dieses Herausführen der Schnittstellen des Testobjektes aus der Testobjektaufnahmeeinrichtung kann sowohl diskret verkabelt beispielsweise über Standardstecker als auch logisch über ein Bussystem erfolgen. Diskret verkabelt bedeutet dabei, dass einer Signalleitung auch eine physikalische Leitung zugeordnet ist, und im Gegensatz dazu wird bei einer logischen Verbindung eine Mehrzahl von Verbindungen über eine gemeinsame physikalische Leitung geführt. Eine logische Verbindung kann in einem Ausführungsbeispiel mit einer Signalumwandlung einhergehen, beispielsweise mit einer Änderung der Signalkodierung oder aber mit einer Analog-Digital-Wandlung.

Fig. 4 zeigt eine schematische Darstellung einer Testumgebung 10 mit einer Mehrzahl von Testfalldurchführungseinheiten 110A, 110B, 110N, einer Mehrzahl von Testobjektaufnahmeeinrichtungen 100A, 100B, 100N mit jeweils einem Testobjekt 105A, 105B, 105N, wobei jedes Testobjekt über jeweils ein Aufnahmeelement 101A, 101B, 101N mit der jeweiligen Testobjektaufnahmeeinrichtung verbunden ist und wobei jede Testobjektaufnahmeeinrichtung über eine externe Anschlussschnittstelle 109A, 109B, 109N über jeweils einen Signalabgriff 180A, 180B, 180N mit dem Verbindungswerk 170 verbunden ist.

Die Testfalldurchführungseinheiten 110 sind mit dem Verbindungswerk über jeweils eine Eingangsschnittstelle 171 und die Testobjektaufnahmeeinrichtungen 100 über jeweils eine Ausgangsschnittstelle 172 verbunden. Wie bereits weiter oben beschrieben, ist das Verbindungswerk ausgeführt, eine jede Eingangsschnittstelle mit einer oder mehreren Ausgangsschnittstellen zu verbinden, wobei eine Ausgangsschnittstelle zu einem Zeitpunkt nur mit einer einzelnen Eingangsschnittstelle verbunden sein kann.

Die Testsignalschnittstelleneinheit 102 der Testobjektaufnahmeeinrichtung 100 kann mit ihrer externen Schnittstelle 102E mit dem dieser Testobjektaufnahmeeinrichtung zugeordneten Signalabgriff gekoppelt sein, so dass der Abgriff von Testsignalen zu Diagnosezwecken über den Signalabgriff 180A, 180B, 180N erfolgen kann.

Aus Übersichtlichkeitsgründen wurde in Fig. 4 darauf verzichtet, eine Simulationshardwareeinheit abzubilden. Es sei daher insbesondere darauf hingewiesen, dass mit dem Verbindungswerk 170 eine Mehrzahl von Testfalldurchführungseinheiten 110, eine Mehrzahl von Testobjektaufnahmeeinrichtungen 100 und eine Mehrzahl von Simulationshardwareeinheiten 150, wie in Fig. 2 dargestellt, verbunden werden können. Dabei kann eine Testfalldurchführungseinheit mit einer oder mehreren Testobjektaufnahmeeinrichtungen zur Durchführung eines Testfalls über das Verbindungswerk gekoppelt sein. Ergänzend dazu kann eine Testobjektaufnahmeeinrichtung bzw. das darin enthaltene Testobjekt über das Verbindungswerk mit einer Simulationshardwareeinheit oder mehreren Simulationshardwareeinheiten gekoppelt sein.

In einem Ausführungsbeispiel ist über das Verbindungswerk 170 auch eine direkte Kopplung der Testobjekte miteinander möglich. Damit kann neben einem einzelnen Testobjekt auch ein Verbund miteinander interagierender Testobjekte getestet werden. Interaktion zwischen Testobjekten bezeichnet dabei beispielsweise eine Verbindung, in der zwei oder mehrere Testobjekte Daten miteinander austauschen, ein Testobjekt Daten von einem anderen Testobjekt anfordert oder ein Testobjekt Aktionen in einem anderen Testobjekt hervorruft bzw. das Ergebnis einer Aktion an ein anderes Testobjekt übermittelt.

Das Verbindungswerk ermöglicht auch die Kopplung räumlich voneinander getrennt angeordneter Testobjekte zu einem gemeinsamen Testszenario.

Damit ermöglicht die Testumgebung wie oben und im Folgenden beschrieben einen gleichzeitigen Mehrfachzugriff auf räumlich verteilte oder nicht verteilte Testobjekte ausgehend von einer Testfalldurchführungseinheit bzw. durch einen Benutzer, einen zeitlich aufeinanderfolgenden Zugriff mehrerer Benutzer bzw. mehrerer Testfalldurchführungseinheiten auf dasselbe Testobjekt, einen gleichzeitigen Zugriff eines Testobjekts auf mehrere Simulationshardwareeinheiten, die räumlich verteilt oder nicht verteilt sein können, und abschließend einen zeitlich aufeinanderfolgenden Zugriff mehrerer verschiedener Testobjekte auf dieselbe Simulationshardwareeinheit. Damit wird ein ressourcenschonender Einsatz der Komponenten der Testumgebung ermöglicht und es muss insbesondere nicht für jedes Testobjekt eine neue, hierauf zugeschnittene Testumgebung entworfen und qualifiziert werden.

## Patentansprüche

1. Testumgebung (10) zum Testen von Testobjekten (105), die Testumgebung (10) aufweisend:
eine erste Testobjektaufnahmeeinrichtung (100A) und eine zweite Testobjektaufnahmeeinrichtung (100B), welche ausgeführt sind, jeweils ein Testobjekt (105) aufzunehmen;
eine Anschlussschnittstelle (172) zum Anschließen der ersten Testobjektaufnahmeeinrichtung (100A) und der zweiten Testobjektaufnahmeeinrichtung (100B) an die Testumgebung;
wobei die erste Testobjektaufnahmeeinrichtung (100A) eine erste externe Anschlussschnittstelle (109A) und die zweite Testobjektaufnahmeeinrichtung (100B) eine zweite externe Anschlussschnittstelle (109B) aufweist, welche externen Anschlussschnittstellen beide ausgeführt sind, wahlweise mit der Anschlussschnittstelle (172) der Testumgebung gekoppelt zu werden;
**dadurch gekennzeichnet, dass**
die erste Testobjektaufnahmeeinrichtung (100A) eine erste interne Schnittstelle (101A) und die zweite Testobjektaufnahmeeinrichtung (100B) eine zweite interne Schnittstelle (101B), welche von der ersten internen Schnittstelle (101A) abweicht, aufweist;
wobei die erste interne Schnittstelle (101A) ausgeführt ist, mit einem ersten Testobjekt (105A) gekoppelt zu werden;
wobei die zweite interne Schnittstelle (101B) ausgeführt ist, mit einem zweiten Testobjekt (105B), welches von dem ersten Testobjekt abweicht, gekoppelt zu werden.

2. Testumgebung (10) nach Anspruch 1,
wobei eine mechanische Spezifikation der ersten externen Anschlussschnittstelle (109A) mit einer mechanischen Spezifikation der zweiten externen Anschlussschnittstelle (109B) übereinstimmt.

3. Testumgebung (10) nach einem der Ansprüche 1 oder 2,
wobei eine elektrische Spezifikation der ersten externen Anschlussschnittstelle (109A) mit einer elektrischen Spezifikation der zweiten externen Anschlussschnittstelle (109B) übereinstimmt.

4. Testumgebung (10) nach einem der vorhergehenden Ansprüche,
wobei eine mechanische Spezifikation der ersten internen Schnittstelle (101A) von einer mechanischen Spezifikation der zweiten internen Schnittstelle (101B) abweicht.

5. Testumgebung (10) nach einem der vorhergehenden Ansprüche,
wobei eine elektrische Spezifikation der ersten internen Schnittstelle (101A) von einer elektrischen Spezifikation der zweiten internen Schnittstelle (101B) abweicht.

6. Testumgebung (10) nach einem der vorhergehenden Ansprüche, die erste Testobjektaufnahmeeinrichtung (100A) weiterhin aufweisend:
eine Signalschnittstelle (103), welche ausgeführt ist, die erste interne Schnittstelle (101A) mit der ersten externen Anschlussschnittstelle (109A) mechanisch und elektrisch zu koppeln.

7. Testumgebung (10) nach einem der vorhergehenden Ansprüche, weiterhin aufweisend:
einen ersten Signalabgriff (180A);
wobei die erste Testobjektaufnahmeeinrichtung (100A) eine erste Testsignalschnittstelle (102) aufweist, welche die erste interne Schnittstelle (101A) mit dem ersten Signalabgriff mechanisch und elektrisch koppelt.

8. Testumgebung (10) nach Anspruch 7,
wobei die zweite Testobjektaufnahmeeinrichtung (100B) eine zweite Testsignalschnittstelle (102) aufweist, welche die zweite interne Schnittstelle (101B) mit dem zweiten Signalabgriff mechanisch und elektrisch koppelt;
wobei die erste Testsignalschnittstelle und die zweite Testsignalschnittstelle eine übereinstimmende elektrische Spezifikation aufweisen, über welche sie mit der Testumgebung gekoppelt sind.

9. Testumgebung (10) nach Anspruch 8,
wobei die erste Testsignalschnittstelle und die zweite Testsignalschnittstelle eine übereinstimmende mechanische Spezifikation aufweisen, über welche sie mit der Testumgebung gekoppelt sind.

## Claims

1. Test environment (10) for testing test objects (105), the test environment (10) having:
a first test object receiving device (100A) and a second test object receiving device (100B) which are designed to receive a respective test object (105);
a connection interface (172) for connecting the first test object receiving device (100A) and the second test object receiving device (100B) to the test environment;
wherein the first test object receiving device (100A) has a first external connection interface (109A) and the second test object receiving device (100B) has a second external connection interface (109B), which external connection interfaces are both designed to be selectively coupled to the connection interface (172) of the test environment;
**characterized in that**
the first test object receiving device (100A) has a first internal interface (101A) and the second test object receiving device (100B) has a second internal interface (101B) which differs from the first internal interface (101A);
wherein the first internal interface (101A) is designed to be coupled to a first test object (105A);
wherein the second internal interface (101B) is designed to be coupled to a second test object (105B) which differs from the first test object.

2. Test environment (10) according to Claim 1,
wherein a mechanical specification of the first external connection interface (109A) corresponds to a mechanical specification of the second external connection interface (109B) .

3. Test environment (10) according to either of Claims 1 and 2,
wherein an electrical specification of the first external connection interface (109A) corresponds to an electrical specification of the second external connection interface (109B) .

4. Test environment (10) according to one of the preceding claims,
wherein a mechanical specification of the first internal interface (101A) differs from a mechanical specification of the second internal interface (101B).

5. Test environment (10) according to one of the preceding claims,
wherein an electrical specification of the first internal interface (101A) differs from an electrical specification of the second internal interface (101B).

6. Test environment (10) according to one of the preceding claims, the first test object receiving device (100A) further having:
a signal interface (103) which is designed to mechanically and electrically couple the first internal interface (101A) to the first external connection interface (109A).

7. Test environment (10) according to one of the preceding claims, further having:
a first signal tap (180A);
wherein the first test object receiving device (100A) has a first test signal interface (102) which mechanically and electrically couples the first internal interface (101A) to the first signal tap.

8. Test environment (10) according to Claim 7,
wherein the second test object receiving device (100B) has a second test signal interface (102) which mechanically and electrically couples the second internal interface (101B) to the second signal tap;
wherein the first test signal interface and the second test signal interface have a corresponding electrical specification by means of which they are coupled to the test environment.

9. Test environment (10) according to Claim 8,
wherein the first test signal interface and the second test signal interface have a corresponding mechanical specification by means of which they are coupled to the test environment.

## Revendications

1. Environnement de test (10) pour tester des objets à tester (105), l'environnement de test (10) comprenant:
un premier dispositif de logement d'objet à tester (100A) et un second dispositif de logement d'objet à tester (100B), qui sont réalisés en vue de contenir chacun un objet à tester (105),
une interface de raccordement (172) destinée à raccorder le premier dispositif de logement d'objet à tester (100A) et le second dispositif de logement d'objet à tester (100B) à l'environnement de test;
dans lequel le premier dispositif de logement d'objet à tester (100A) présente une première interface de raccordement externe (109A) et le second dispositif de logement d'objet à tester (100B) présente une seconde interface de raccordement externe (109B), les deux interfaces de raccordement externes étant réalisées pour être couplées au choix à l'interface de raccordement (172) de l'environnement de test;
**caractérisé en ce que**
le premier dispositif de logement d'objet à tester (100A) présente une première interface interne (101A) et le second dispositif de logement d'objet à tester (100B) présente une seconde interface interne (101B), qui diffère de la première interface interne (101A);
dans lequel la première interface interne (101A) est réalisée en vue d'être couplée à un premier objet à tester (105A);
dans lequel la seconde interface interne (101B) est réalisée en vue d'être couplée à un second objet à tester (105B), qui diffère du premier objet à tester.

2. Environnement de test (10) selon la revendication 1, dans lequel une spécification mécanique de la première interface de raccordement externe (109A) concorde avec une spécification mécanique de la seconde interface de raccordement externe (109B).

3. Environnement de test (10) selon une des revendications 1 ou 2, dans lequel une spécification électrique de la première interface de raccordement externe (109A) concorde avec une spécification électrique de la seconde interface de raccordement externe (109B).

4. Environnement de test (10) selon l'une quelconque des revendications précédentes, dans lequel une spécification mécanique de la première interface interne (101A) diffère d'une spécification mécanique de la seconde interface interne (101B).

5. Environnement de test (10) selon l'une quelconque des revendications précédentes, dans lequel une spécification électrique de la première interface interne (101A) diffère d'une spécification électrique de la seconde interface interne (101B).

6. Environnement de test (10) selon l'une quelconque des revendications précédentes, dans lequel le premier dispositif de logement d'objet à tester (100A) comprend en outre une interface de signal (103), qui est réalisée en vue de coupler mécaniquement et électriquement la première interface interne (101A) à la première interface de raccordement externe (109A).

7. Environnement de test (10) selon l'une quelconque des revendications précédentes, comprenant en outre:
une première prise de signal (180A);
dans lequel le premier dispositif de logement d'objet à tester (100A) présente une première interface de signal de test (102), qui couple mécaniquement et électriquement la première interface interne (101A) à la première prise de signal.

8. Environnement de test (10) selon la revendication 7,
dans lequel le second dispositif de logement d'objet à tester (100B) présente une seconde interface de signal de test (102), qui couple mécaniquement et électriquement la seconde interface interne (101B) à la seconde prise de signal;
dans lequel la première interface de signal de test et la seconde interface de signal de test présentent une spécification électrique concordante, par laquelle elles sont couplées à l'environnement de test.

9. Environnement de test (10) selon la revendication 8, dans lequel la première interface de signal de test et la seconde interface de signal de test présentent une spécification mécanique concordante, par laquelle elles sont couplées à l'environnement de test.
